# EUROPÄISCHE PATENTSCHRIFT

(11) **EP 3 032 366 B1**
(45) Veröffentlichungstag und Bekanntmachung des Hinweises auf die Patenterteilung: **19.08.2020**
(21) Anmeldenummer: 15194683.7
(22) Anmeldetag: 16.11.2015
(51) Int. Cl.: G05B 19/05, G06F 13/16, G06F 13/40

(54) **AUTOMATISIERUNGSGERÄT UND VERFAHREN ZUM BETREIBEN EINES AUTOMATISIERUNGSGERÄTS**
AUTOMATION DEVICE AND METHOD FOR OPERATING AN AUTOMATION DEVICE
APPAREIL D'AUTOMATISATION ET PROCEDE DE FONCTIONNEMENT D'UN APPAREIL D'AUTOMATISATION

(30) Priorität: 11.12.2014 DE 102014118389
(43) Veröffentlichungstag der Anmeldung: 15.06.2016
(73) Patentinhaber: Weidmüller Interface GmbH & Co. KG, 32758 Detmold (DE)
(72) Erfinder: ROSE, Gorm, 33100 Paderborn (DE); STRÜNKMANN, Marc, 33104 Paderborn (DE); KULTURIDI, Georg, 33605 Bielefeld (DE)
(74) Vertreter: Kleine, Hubertus

(56) Entgegenhaltungen:
- EP-A1- 2 605 092
- EP-A1- 2 899 640

## Beschreibung

Die Erfindung betrifft ein Automatisierungsgerät mit einem Hauptmodul und einem austauschbaren Anschlussmodul, in dem ein Feldbusanschluss des Automatisierungsgeräts angeordnet ist. Die Erfindung betrifft weiterhin ein Betriebsverfahren für ein Automatisierungsgerät mit einem austauschbaren Anschlussmodul.
In industriellen Automatisierungssystemen werden Feldbusse zur Übertragung von Steuerungsdaten und/oder Messwerten zwischen einem oder mehreren Steuerungsrechnern, auch Leitrechner oder speicherprogrammierbare Steuerung (SPS) genannt, und Feldgeräten ausgetauscht. Zu den Feldgeräten gehören unter anderem Ein- und Ausgangsmodule, nachfolgend abgekürzt I/O (Input/Output)-Module genannt, die analoge und/oder digitale Ein- und/oder Ausgangskanäle bereitstellen, über die Anlagenkomponenten gesteuert werden können und Messwerte, beispielsweise von Sensoren, eingelesen werden können. Häufig wird dabei nicht jedes einzelne Feldgerät unmittelbar an den Feldbus angeschlossen, sondern über einen sogenannten Feldbuskoppler, der eine Datenschnittstelle zwischen dem Feldbus einerseits und einem häufig proprietären Subbus andererseits darstellt. An den Subbus kann eine Mehrzahl von busfähigen Modulen, beispielsweise den genannten I/O- Modulen, angekoppelt werden.

Im Rahmen der Anmeldung wird als ein Automatisierungsgerät nachfolgend sowohl Steuerungsrechner, als auch Feldbuskoppler verstanden.

In industriellen Automatisierungssystemen haben sich unterschiedliche Feldbussysteme etabliert. Zu diesen gehören beispielsweise Profibus, Profinet und EtherCAD. Um Automatisierungsgeräte nicht in einer Mehrzahl unterschiedlicher Ausgestaltungen für die unterschiedlichen Feldbussysteme bereitstellen zu müssen, sind Automatisierungsgeräte mit austauschbaren Anschlussmodulen für die unterschiedlichen Feldbussysteme bekannt, beispielsweise aus den Druckschriften EP 2605092 A1, EP 2899640 A1 und

DE 10 2004 056 363 A1. Das modulare Anschlusskonzept verringert die Entwicklungs-, Herstellungs- und Lagerhaltungskosten der Automatisierungsgeräte. Für Anwender der Automatisierungsgeräte ermöglicht das modulare System zudem einen leichteren Wechsel des Feldbussystems in einer bereits bestehenden Anlage bzw. die Wiederverwendung von Automatisierungsgeräten in neuen Anlagen auch mit einem anderen als den bisher eingesetzten Feldbussystemen.

Bei einem derartigen modularen System besteht jedoch die Gefahr, ein Automatisierungsgerät mit einem nicht geeigneten Anschlussmodul zu betreiben. Bestimmte Paarungen von Automatisierungsgerät und Anschlussmodul können aus hardwaretechnischen, softwaretechnischen und/oder lizenzrechtlichen Gründen nicht zulässig sein.

Es ist eine Aufgabe der vorliegenden Erfindung, ein Automatisierungsgerät der eingangs genannten Art bei dem Kompatibilitätsprobleme zwischen dem Haupt- und dem Anschlussmodul unterbunden sind. Es ist eine weitere Aufgabe, ein Betriebsverfahren für ein solches Automatisierungsgerät zu schaffen.

Diese Aufgabe wird gelöst durch ein Automatisierungsgerät, bzw. ein Verfahren mit den jeweiligen Merkmalen der unabhängigen Ansprüche. Vorteilhafte Ausgestaltungen und Weiterbildungen sind in den abhängigen Ansprüchen angegeben.

Ein erfindungsgemäßes Automatisierungsgerät der eingangs genannten Art zeichnet sich dadurch aus, dass in dem Anschlussmodul ein nichtflüchtiger Speicher angeordnet ist, der von dem Hauptmodul des Automatisierungsgeräts auslesbar ist.

In dem nichtflüchtigen Speicher des Anschlussmoduls können Informationen über die Kompatibilität der verschiedenen Geräte abgelegt werden. Auf diese Weise kann das Automatisierungsgerät nach Kopplung mit dem Anschlussmodul abfragen, ob das genannte Anschlussmodul aus hardwaretechnischen, softwaretechnischen oder lizenzrechtlichen Gründen zur Zusammenarbeit mit dem Hauptmodul des Automatisierungsgeräts geeignet und zulässig ist. Weiterhin ist es möglich, Programme oder Programmelemente oder Programmabschnitte in dem nichtflüchtigen Speicher des Anschlussmoduls vorzuhalten, die nach Kopplung mit einem Automatisierungsgerät von diesem eingelesen werden und eine möglicherweise zuvor bestehende und durch Software bedingte Inkompatibilität beheben.

In einer vorteilhaften Ausgestaltung des Automatisierungsgerätes ist der nichtflüchtige Speicher des Anschlussmoduls ein Flashspeicher, ein ferroelektrischer Speicher (FRAM - Ferroelectric Random Access Memory) oder ein EEPROM (Electrically Erasable Programmable Read-Only Memory). Bevorzugt ist der nichtflüchtige Speicher zudem auf einer Leiterplatte des Anschlussmoduls fest eingelötet, wobei auf der Leiterplatte Bausteine eines Schnittstellentreibers und/oder einer zentralen Steuereinheit zum Betreiben des Feldbusanschlusses des Anschlussmoduls angeordnet sind. Die Integration des nichtflüchtigen Speichers auf die Leiterplatte des Feldbusanschlusses erschwert Manipulationen an dem Anschlussmodul.

In einer weiteren bevorzugten Ausgestaltung ist der nichtflüchtige Speicher mit einer Steuereinheit oder einem Schnittstellentreiber für den Feldbusanschluss des Anschlussmoduls verbunden. Auf diese Weise kann der nichtflüchtige Speicher auch verwendet werden, um zu speichernde Informationen für das Anschlussmodul, beispielsweise eine sogenannte Firmware des Anschlussmoduls aufzunehmen.

In einer weiteren vorteilhaften Ausgestaltung des Automatisierungsgerätes weist das Anschlussmodul einen Steckverbinder zur Verbindung mit dem Hauptmodul des Automatisierungsgeräts auf, wobei der Steckverbinder im Anschlussmodul mit dem nichtflüchtigen Speicher gekoppelt ist. Dabei kann die Kopplung zwischen dem Steckverbinder und dem nichtflüchtigen Speicher unmittelbar über einen dem nichtflüchtigen Speicher zugeordneten Schnittstellentreiber erfolgt. In dem Fall stellt der genannte Steckverbinder einen separaten Datenkanal zum Übertragen der Daten des nichtflüchtigen Speichers an das Hauptmodul bereit. Dabei kann ein eigens für diesen Datenkanal genutzter Steckverbinder vorgesehen sein oder auch ein Teil eines auch anderweitig genutzten Steckverbinders für diesen Datenkanal genutzt werden.

Alternativ ist es möglich, dass der nichtflüchtige Speicher über einen Schnittstellentreiber mit einer zentralen Steuereinheit des Anschlussmoduls verbunden und über die Steuereinheit und ggf. einen weiteren Schnittstellentreiber mit dem Steckverbinder gekoppelt ist. In diesem Fall wird nur ein Datenkanal zwischen dem Hauptmodul und dem Anschlussmodul aufgebaut, über den sowohl die Daten aus dem nichtflüchtigen Speicher an das Hauptmodul übertragen werden, als auch die die Feldbus-Daten ausgetauscht werden.

In einer weiteren vorteilhaften Ausgestaltung des Automatisierungsgerätes weisen das Hauptmodul und/oder das Anschlussmodul Kupplungsmittel zur mechanischen Verbindung des Anschlussmoduls an das Hauptmodul auf. Bevorzugt sind die Kupplungsmittel als Rasthaken ausgebildet.

In einer weiteren vorteilhaften Ausgestaltung des Automatisierungsgeräts sind das Hauptmodul und/oder das Anschlussmodul zur Montage auf einer Tragschiene ausgebildet und weisen insbesondere eine Hutschienenaufnahme auf. Zusätzlich zur mechanischen Verbindung von Hauptmodul und Anschlussmodul untereinander kann so eine mechanisch solide Anordnung des Automatisierungsgeräts beispielsweise in einem Schaltschrank erfolgen.

In weiteren Ausgestaltungen des Automatisierungsgerätes ist dieses ein Feldbuskoppler und/ oder ein Steuerungsrechner.

Ein erfindungsgemäßes Anschlussmodul für ein Automatisierungsgerät zeichnet sich dadurch aus, dass ein nichtflüchtiger Speicher in dem Anschlussmodul angeordnet ist, der über einen an dem Anschlussmodul angeordneten Steckverbinder von einem Hauptmodul des Automatisierungsgeräts auslesbar ist.

Ein erfindungsgemäßes Verfahren zum Betreiben eines Automatisierungsgeräts umfasst die folgenden Schritte: Es wird ein Hauptmodul des Automatisierungsgeräts mit einem Anschlussmodul verbunden und ein nichtflüchtigen Speichers des Anschlussmoduls durch das Hauptmodul ausgelesen. Dann werden eventuell vorliegende Inkompatibilitäten zwischen dem Hauptmodul und dem Anschlussmodul ermittelt. Das Automatisierungsgerät wird anschließend betreiben, wenn keine Inkompatibilitäten festgestellt wurden.

Bei dem erfindungsgemäßen Anschlussmodul und dem erfindungsgemäßen Verfahren ergeben sich die zuvor im Zusammenhang mit dem Automatisierungsgerät genannten Vorteile.

Bei einer vorteilhaften Ausgestaltung des Verfahrens werden Daten des nichtflüchtigen Speichers des Anschlussmoduls innerhalb des Hauptmoduls zur Behebung eventuell festgestellter Inkompatibilitäten eingesetzt. Bei einer weiteren vorteilhaften Ausgestaltung werden Daten des nichtflüchtigen Speichers des Anschlussmoduls zur Aktualisierung von Betriebssoftware, insbesondere Firmware, des Hauptmoduls eingesetzt.

Bei einer weiteren vorteilhaften Ausgestaltung des Verfahrens wird von dem Anschlussmodul zusätzlich ein funkbasierter Kommunikationskanal bereitgestellt. Über den funkbasierten Kommunikationskanal kann beispielsweise ein Laptop- oder ein Tablet-Computer zu Diagnose- oder Einrichtungszwecken über das Anschlussmodul mit dem Hauptmodul gekoppelt werden. Das Anschlussmodul erweitert so das Hauptmodul bei Bedarf zusätzlich um diese Verbindungsmöglichkeit. Die Modularität und Nachrüstbarkeit des Systems wird weiter erhöht. Der funkbasierte Kommunikationskanal kann z.B. auf einem WLAN (Wireless Local Area Network)-, NFC (Near Field Communication)-, Zigbee- oder Bluetooth-Standard basieren.

Die Erfindung wird nachfolgend anhand von Ausführungsbeispielen mithilfe von Figuren näher erläutert. Die Figuren zeigen:
- Figur 1a, b: eine perspektivische Zeichnung eines Automatisierungsgeräts in einem Ausführungsbeispiel mit zusammengesetztem (Figur 1a) bzw. voneinander getrenntem (Figur 1b) Haupt- und Anschlussmodul ;
- Figur 2: eine Seitenansicht des Automatisierungsgeräts aus Figur 1b;
- Figur 3: eine Draufsicht auf ein Hauptmodul und verschiedene Anschlussmodule eines Automatisierungsgeräts;
- Figur 4a bis c: verschiedene Kombinationen von Haupt- und Anschlussmodul(en) in jeweils einer Draufsicht;
- Figur 5: ein Blockschaltbild eines Automatisierungsgeräts;
- Figur 6a, b: eine perspektivische Zeichnung eines Automatisierungsgeräts in einem weiteren Ausführungsbeispiel mit zusammengesetztem (Figur 6a) bzw. getrenntem (Figur 6b) Haupt- und Anschlussmodul ;
- Figur 7: eine Seitenansicht des Automatisierungsgeräts aus Figur 6b; und
- Figur 8: eine Draufsicht auf das Automatisierungsgerät aus Figur 6a.

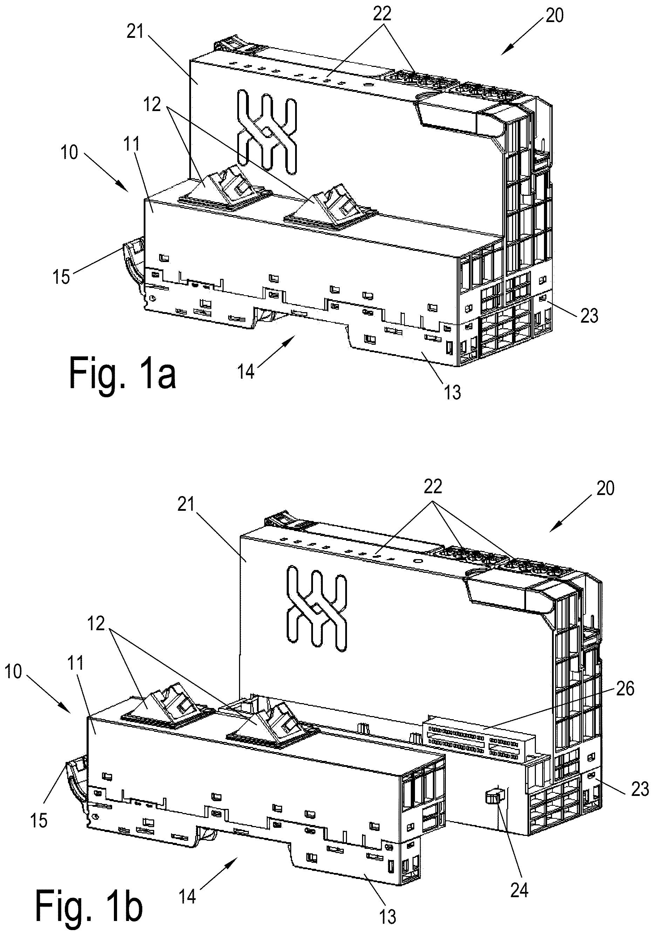

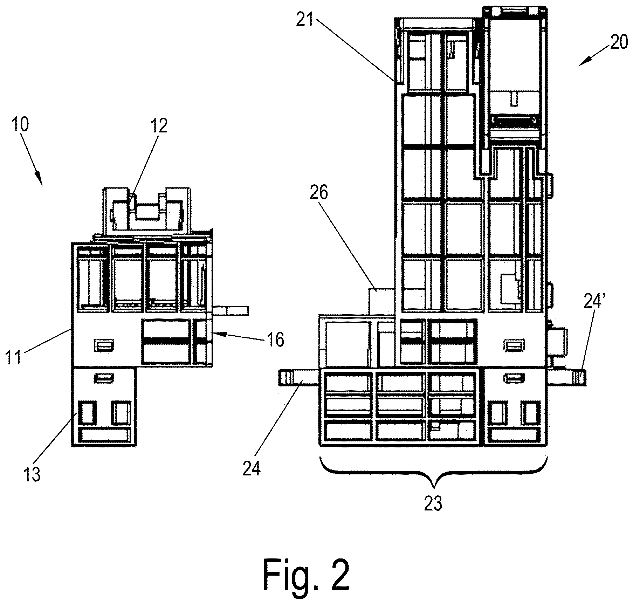

In den Figuren 1a, 1b und 2 ist ein erstes Ausführungsbeispiel eines Automatisierungsgerätes gemäß der Anmeldung in perspektivischen Zeichnungen (Figur 1a, 1b) bzw. einer Seitenansicht (Figur 2) dargestellt. Das gezeigte Automatisierungsgerät ist in diesem Ausführungsbeispiel ein Feldbuskoppler.

Der Feldbuskoppler umfasst ein Feldbuskoppler-Hauptmodul 20, nachfolgend abgekürzt als Hauptmodul 20 bezeichnet, sowie ein daran angesetztes Anschlussmodul 10. Figur 1a zeigt den Feldbuskoppler im zusammengesetzten Zustand, wohingegen in den Figuren 1b und 2 das Anschlussmodul 10 vom Hauptmodul 20 getrennt ist.

Das Hauptmodul 20 umfasst ein Gehäuseoberteil 21, das an seiner Oberseite Anzeige- und Anschlusselement 22 aufweist. Das Gehäuseoberteil 21 ist auf ein Gehäuseunterteil 23 aufgesetzt, das in dem dargestellten Ausführungsbeispiel für eine Montage auf einer Tragschiene, insbesondere einer Hutschiene, ausgebildet ist. In den dargestellten Figuren ist eine entsprechende Hutschienenaufnahme des Hauptmoduls 20 nicht sichtbar.

Das Anschlussmodul 10 weist in diesem Ausführungsbeispiel ein ebenfalls mehrteiliges, hier auch zweiteiliges Gehäuse auf mit einem Gehäuseoberteil 11 und einem Gehäuseunterteil 13. Auf einer Oberseite des Anschlussmoduls 10 sind Feldbusanschlüsse 12 ausgebildet, bei dem gezeigten Ausführungsbeispiel zwei Feldbusanschlüsse 12 zur Aufnahme von Steckern der Bauform "RJ-45". Das dargestellte Anschlussmodul 10 ist beispielsweise für einen EtherCAD- Feldbus geeignet.

Im Gehäuseunterteil 13 des Anschlussmoduls 10 ist ebenfalls eine Tragschienenaufnahme vorgesehen, hier ausgebildet als Hutschienenaufnahme 14. Die Hutschienenaufnahme 14 weist einen beispielsweise seitlich wirkenden Rastschiebers auf, mit dem sie auf einer Hutschiene verrasten kann. Zum Lösen der Verbindung mit der Hutschiene ist ein seitlicher Entriegelungshebel 15 vorgesehen.

Wie die Figur 1a zeigt, kann das Anschlussmodul 10 bündig an das Hauptmodul 20 angesetzt werden, wobei es mechanisch mit diesem koppelt, insbesondere verastet. Zu diesem Zweck sind am Hauptmodul 20 Kupplungsmittel 24 angeordnet, hier in Form von Rasthaken, die in den Figuren 1b und 2 sichtbar sind. Die Kupplungsmittel 24 greifen in entsprechend hinterschnittene Rastelemente des Anschlussmoduls 10 ein.

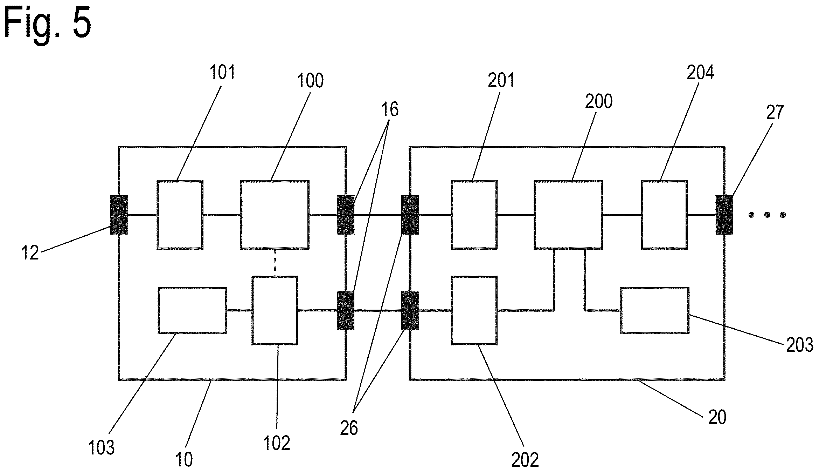

Zur elektrischen Verbindung des Anschlussmoduls 10 an das Hauptmodul 20 ist am Anschlussmodul 10 ein Steckverbinder 16 und am Hauptmodul 20 ein dazu komplementärer Gegensteckverbinder 26 angeordnet. Bei gekoppeltem Hauptmodul 20 und Anschlussmodul 10 werden über Steckverbinder 16 und Gegensteckverbinder 26 Signale zur Ansteuerung der Feldbusanschlüsse 12 zwischen den beiden Modulen übertragen. Weiterhin wird ein im Anschlussmodul 10 integrierter nichtflüchtiger Speicher über Steckverbinder 16 und gegen Steckverbinder 26 derart mit Steuereinrichtungen des Hauptmoduls 20 verbunden, dass vom Hauptmodul 20 auf Inhalte des nichtflüchtigen Speichers im Anschlussmodul 10 zugegriffen werden kann. Dieses wird im Zusammenhang mit dem schematischen Blockschaltbild der Figur 5 nachfolgend näher erläutert.

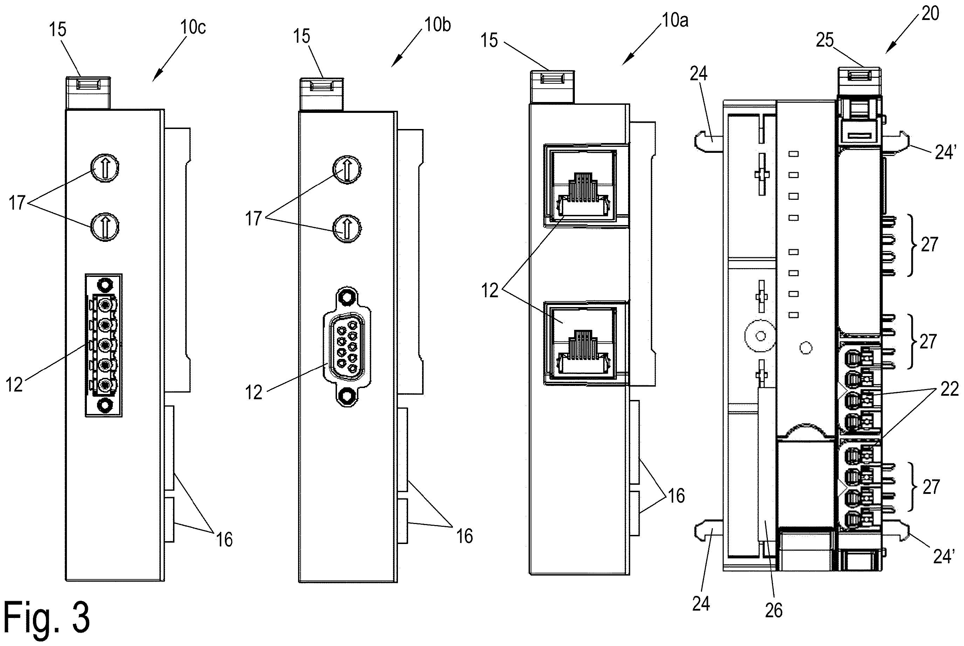

In der Figur 3 sind das Hauptmodul 20 und das Anschlussmodul 10 der Figur 1 und 2 nochmals in einer Draufsicht im voneinander entkoppelten Zustand dargestellt. Das Anschlussmodul ist hier mit dem Bezugszeichen 10a versehen.

Gekennzeichnet mit den Bezugszeichen 10b und 10c sind zwei weitere Ausgestaltungen eines Anschlussmoduls 10 zur Verwendung mit dem Hauptmodul 20 des Feldbuskopplers in der Figur 3 wiedergegeben. Diese unterscheiden sich von dem Anschlussmodul 10a durch den Einsatz eines Feldbusanschlusses 12 eines anderen Feldbus-Systems. Das Anschlussmodul 10b kann beispielsweise für einen Profibus-Feldbus geeignet sein.
Weiterhin unterscheiden sich die Anschlussmodule 10b und 10c von dem Anschlussmodul 10a darin, dass Einstellelemente 17 vorgesehen sind, mit denen beispielsweise eine Adresscodierung für den Feldbusanschluss 12 erfolgen kann. Es versteht sich, dass die gezeigten Einstellelemente 17 nicht zwingend auf der Oberseite des Anschlussmoduls 10b, 10c, sondern auch an einer Seitenfläche angeordnet sein können. Für Einstellelemente, die nach Möglichkeit nicht versehentlich verstellt werden sollen, ist auch eine Anordnung an der zum Hauptmodul 20 hinweisenden Seite vorteilhaft. Es wird angemerkt, dass neben den dargestellten Einstellelementen 17 auch Anzeigeelemente z.B. in Form von Leuchtdioden am Anschlussmodul 10 vorgesehen sein können.

In der Draufsicht der Figur 3 ist beim Hauptmodul 20 ebenfalls ein Entriegelungshebel 25 zu erkennen, der zum Lösen der hier nicht sichtbaren am Hauptmodul 20 vorgesehenen Hutschienenaufnahme dient.

An der dem Anschlussmodul 10 gegenüberliegenden Seite weist das Hauptmodul 20 weitere Kupplungsmittel 24' auf, die baugleich zu den Kupplungsmitteln 24 ausgebildet sind. Mittels dieser weiteren Kupplungsmittel 24' erfolgt die mechanische Kopplung zu busfähigen Modulen, beispielsweise IO-Modulen, die an das Feldbuskoppler-Hauptmodul 20 angebunden werden.

Zur elektrischen Verbindung derartiger Module sind am Hauptmodul 20 Buskontakte 27 ausgebildet, die einer Stromverteilung zur Stromversorgung und einem Datenaustausch zwischen den busfähigen Modulen und dem Feldbuskoppler 20 dienen. Die im Hinblick auf die mechanische Ausgestaltung gleicher Art der Kopplungen zwischen den busfähigen Modulen und dem Hauptmodul 20 des Feldbuskopplers sowie dem Hauptmodul 20 und dem Anschlussmodul 10 ermöglicht die Wiederverwendung von Gehäusekomponenten. So ist beispielsweise das Gehäuseunterteil 13 des Anschlussmoduls 10 im Wesentlichen identisch mit zumindest einem Teil des Gehäuseunterteils 23 des Hauptmoduls 20. Das Gehäuseunterteil 13 des Anschlussmoduls 10 kann zudem auch bei den busfähigen Modulen Verwendung finden.

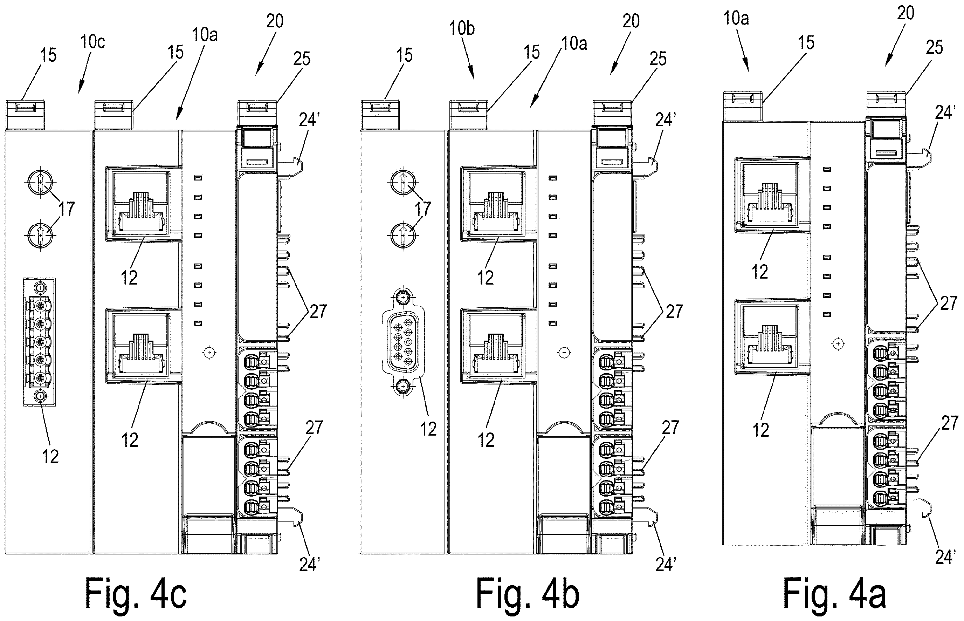

Figur 4a zeigt nochmals eine Draufsicht auf den aus Hauptmodul 20 und Anschlussmodul 10a bestehenden Feldbuskoppler. In den Figuren 4b und 4c sind Konfigurationen des Feldbuskopplers gezeigt, bei denen mehrere Anschlussmodule 10 gleichzeitig verwendet werden.

So zeigt die Figur 4b eine Draufsicht analog zur Figur 4a, bei der sich an die Kombination von Hauptmodul 20 und das Anschlussmodul 10a ein Anschlussmodul 10b als weiteres Anschlussmodul anschließt. Zu diesem Zweck ist das Anschlussmodul 10a in diesem Ausführungsbeispiel so ausgebildet, dass es seinerseits Kupplungsmittel analog zu den Kupplungsmitteln 24 des Hauptmoduls 20 aufweist, mit denen die mechanische Verbindung zu dem Anschlussmodul 10b vorgenommen werden kann. Weiterhin sind an der dem Anschlussmodul 10b zugewandten Seite des Anschlussmoduls 10a Gegensteckverbinder analog zu den Gegensteckverbindern 26 des Kopplungsmoduls 20 ausgebildet, über die eine elektrische Verbindung zwischen den beiden Anschlussmodulen 10a, 10b erfolgt.

Zwischen dem Hauptmodul 20 und dem Anschlussmodul 10b ausgetauschte Daten werden von dem Anschlussmodul 10a über die Kombination aus Gegensteckverbinder 26 und Steckverbinder 16 bzw. die Kombination aus dem genannten Gegensteckverbinder und dem Steckverbinder 16 des Anschlussmoduls 10b weitergeleitet. Auf diese Weise kann ein Datenaustausch sowohl zwischen Hauptmodul 20 und Anschlussmodul 10a, als auch zwischen Hauptmodul 20 und Anschlussmodul 10b erfolgen.

In gleicher Weise wie in Figur 4b ist in Figur 4c eine Konfiguration dargestellt, bei der das Hauptmodul 20 des Feldbuskopplers mit einem ersten Anschlussmodul 10a verbunden ist, an das sich ein zweites Anschlussmodul 10c anschließt.

Figur 5 zeigt eine Kombination eines Hauptmoduls 20 und eines Anschlussmoduls 10 eines anwendungsgemäßen Automatisierungsgeräts in einem Blockschaltbild. Beispielsweise kann es sich um das Hauptmodul 20 und das Anschlussmodul 10 bzw. 10a bis 10c gemäß den Figuren 1 bis 4 handeln.

Das Hauptmodul 20 umfasst eine zentrale Steuereinheit 200, beispielsweise einen Mikrocontroller. Dieser ist mit Schnittstellentreibern 201, 202 und 204 verbunden, über die die Steuereinheit 200 mit verschiedenen Anschlüssen verbunden ist. Die Schnittstellentreiber 201 und 202 kontaktieren den Gegensteckverbinder 26, über den die elektrische Verbindung zu dem Anschlussmodul 10 erfolgt. Der Schnittstellentreiber 204 koppelt die Steuereinheit 200 mit dem Busanschluss 27, an den die busfähigen Module (IO-Module) angeschlossen sind. Weiterhin ist die Steuereinheit 200 mit einem Speicher 203 verbunden. Dieser Speicher kann flüchtige und/oder nichtflüchtige Speicherbereiche aufweisen. Ein zur Ansteuerung des Speichers 203 eventuell benötigter Schnittstellentreiber ist aus Gründen der Übersicht hier nicht eingetragen.

Das Anschlussmodul 10 umfasst in dem dargestellten Ausführungsbeispiel ebenfalls eine zentrale Steuereinheit 100, die wiederum durch einen Mikrocontroller gebildet sein kann. Verbunden mit der Steuereinheit 100 ist ein Feldbus-Schnittstellentreiber 101, an dem der Feldbusanschluss 12 angekoppelt ist. Informationen werden zwischen dem Anschlussmodul 10 und dem Hauptmodul 20 zwischen den Schnittstellentreibern 101 und 201, gegebenenfalls unter Zwischenschaltung der Steuereinheit 100 ausgetauscht. Dabei kann ein proprietäres Protokoll verwendet werden, das nicht dem Protokoll des Feldbusanschlusses 12 entspricht. Falls das Protokoll des Feldbusanschlusses 12 auch bei der Übertragung der Informationen zwischen dem Anschlussmodul 10 und dem Hauptmodul 20 Auch die hardwaretechnische Ausbildung ("physical layer") der Datenübertragung über den Steckverbinder 16 bzw. den Gegensteckverbinder 26 muss nicht der des Feldbusanschlusses 12 entsprechen. Es erfolgt eine Umsetzung des Protokolls in der Steuereinheit 100 oder dem Feldbus-Schnittstellentreiber 101. Es ist jedoch auch denkbar, dass die Informationsübertragung zwischen den Schnittstellentreibers 101 und 201 auf demselben Protokoll bzw. derselben hardwaretechnischen Spezifikation beruht, die für den Feldbusanschluss 12 verwendet werden.

Erfindungsgemäß weist das Anschlussmodul 10 den nichtflüchtigen Speicher 103, beispielsweise einen Flashspeicher, einen ferroelektrischen Speicher (FRAM - Ferroelectric Random Access Memory) oder ein EEPROM (Electrically Erasable Programmable Read-Only Memory), auf. Dessen Informationen werden in dem dargestellten Ausführungsbeispiel über den Schnittstellentreiber 102 sowie die Kombination aus Steckverbinder 16 und Gegensteckverbinder 26 sowie einem Schnittstellentreiber 202 durch die Steuereinheit 200 des Hauptmoduls 20 auslesbar. Im dargestellten Ausführungsbeispiel ist der verwendete Daten-Übertragungsweg für diese Informationen getrennt von dem Übertragungsweg der Daten, die am Feldbusanschluss 12 ausgegeben werden. Entsprechend können Signalleitungen des Steckverbinders 16 bzw. des Gegensteckverbinders 26 für die unterschiedlichen Datenwege getrennt vorgesehen sein. Bei dem Ausführungsbeispiel der Figur 3 ist dieses auch anhand einer räumlichen Trennung der verschiedenen Bereiche des Steckverbinders 16 erkennbar, wobei jedoch in dem Ausführungsbeispiel ein gemeinsames Steckergehäuse verwendet wird. In alternativen Ausgestaltungen kann bei einem gemeinsamen Steckergehäuse auch auf eine räumliche Trennung der verschiedenen Bereiche des Steckers verzichtet werden, insbesondere wenn die in den unterschiedlichen Bereichen anliegenden Signalpegel von vergleichbarer Größenordnung sind.

Bei einem erfindungsgemäßen Verfahren greift das Automatisierungsgerät von dem Hauptmodul auf den im Anschlussmodul angeordneten nichtflüchtigen Speicher zu. Ein Ausführungsbeispiel eines derartigen Verfahrens wird nachfolgend beispielhaft anhand des in Figur 5 schematisch dargestellten Feldbuskopplers erläutert.

Beispielsweise nach einem Start des Hauptmoduls 20 greift die Steuereinheit 200 auf den Schnittstellentreiber 202 zu, um abzufragen, ob an dem Steckverbinder 26 ein Anschlussmodul 10 angeschlossen ist. Wenn ein derartiges Anschlussmodul 10 angeschlossen ist, etabliert der Schnittstellentreiber 202 über den Gegensteckverbinder 26 und den Steckverbinder 16 eine Kommunikation mit dem Schnittstellentreiber 102 für den nichtflüchtigen Speicher 103. Die Verbindung zwischen den beiden Schnittstellentreibern 102 und 202 kann sich dabei einer bekannten Spezifikation bedienen, beispielsweise gemäß der USB (Universal Serial Bus)- Spezifikation ausgebildet sein. Wenn das Vorhandensein eines Anschlussmoduls 10 festgestellt wird und eine Kommunikationsverbindung zwischen den Schnittstellentreibern 102 und 202 aufgebaut ist, greift der Mikrocontroller 200 auf den Inhalt des nichtflüchtigen Speichers 103 zu. Es wird angemerkt, dass in weiteren Ausgestaltungen des Anschlussmoduls10 auch vorgesehen sein kann, den nichtflüchtigen Speicher 103 unmittelbar, also ohne den Schnittstellentreiber 102 mit dem Steckverbinder 16 zu koppeln. Der nichtflüchtigen Speichers 103 wird dann unmittelbar von dem Hauptmoduls 20 angesprochen.

Anhand von abgelegten Kompatibilitätsdaten in dem nichtflüchtigen Speicher 103 kann die Steuereinheit 200 sodann feststellen, ob das angeschlossene Anschlussmodul 10 kompatibel mit dem Hauptmodul 20 ist. Weiter können im nichtflüchtigen Speicher 103 Lizenzdaten abgelegt sein, anhand derer festgestellt werden kann, ob das Hauptmodul 20 zur Verwendung mit dem Feldbus, der an den Feldbusanschluss 12 des Anschlussmoduls 10 anschließbar ist, lizensiert ist.

Weiterhin ist es möglich, im nichtflüchtigen Speicher 103 Programmabschnitte oder Programme abzulegen, die von der Steuereinheit 200 eingelesen werden und gegebenenfalls zur Aktualisierung von Steuerprogrammen, beispielsweise der sogenannten Firmware der Steuereinheit 200 des Hauptmoduls 20, verwendet werden können. Eine derartige Firmware ist beispielsweise im Speicher 203 des Hauptmoduls 20 abgelegt und wird entsprechend anhand der Informationen aus dem nichtflüchtigen Speicher 103 aktualisiert. Auf diese Weise wird erreicht, dass auch an ein älteres Hauptmodul 20, das softwareseitig zunächst nicht zur Verwendung mit einem bestimmten Feldbustyp eingerichtet ist, ein neueres Anschlussmodul 10 für eine neuere oder aktualisierte Feldbusvariante angeschlossen werden kann. Nach Anschluss dieses Anschlussmoduls 10 erfolgt automatisch eine Anpassung der Software des Hauptmoduls 20, sodass dieses dann zur Verwendung mit dem Anschlussmodul 10 eingerichtet ist.

Um Manipulationen an dem Anschlussmodul 10 zu verhindern kann vorgesehen sein, den nichtflüchtigen Speicher 103 fest auf einer Leiterplatte des Anschlussmoduls 10 einzulöten. Weiterhin kann vorgesehen sein, relevante Informationen, beispielsweise über Kompatibilitäten und/oder Lizenzdaten in dem nichtflüchtigen Speicher 103 in verschlüsselter Form abzulegen. Eine Entschlüsselung erfolgt bevorzugt durch die Steuereinheit 200 nach Auslesen des Inhalts des Speichers 103 mit Schlüsseldaten, die im Hauptmodul 20, beispielsweise in Speicher 203 hinterlegt sind.

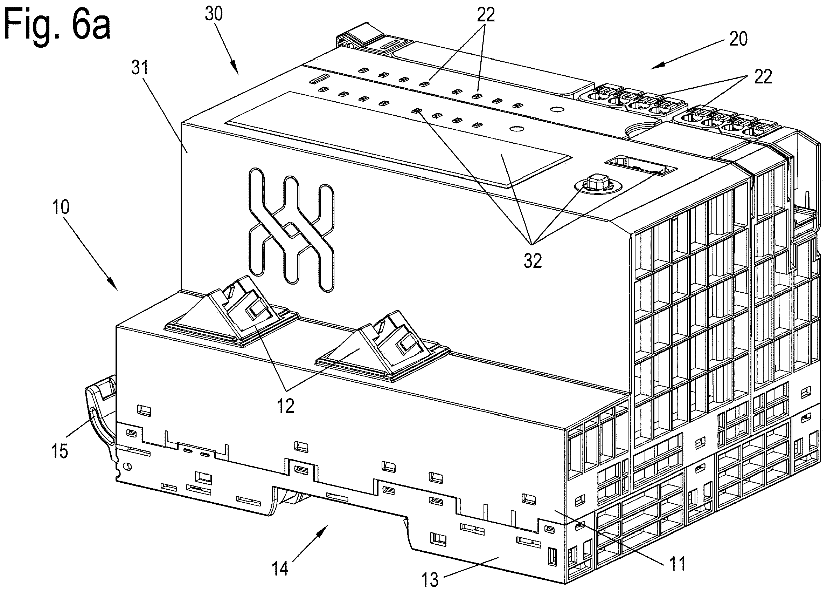

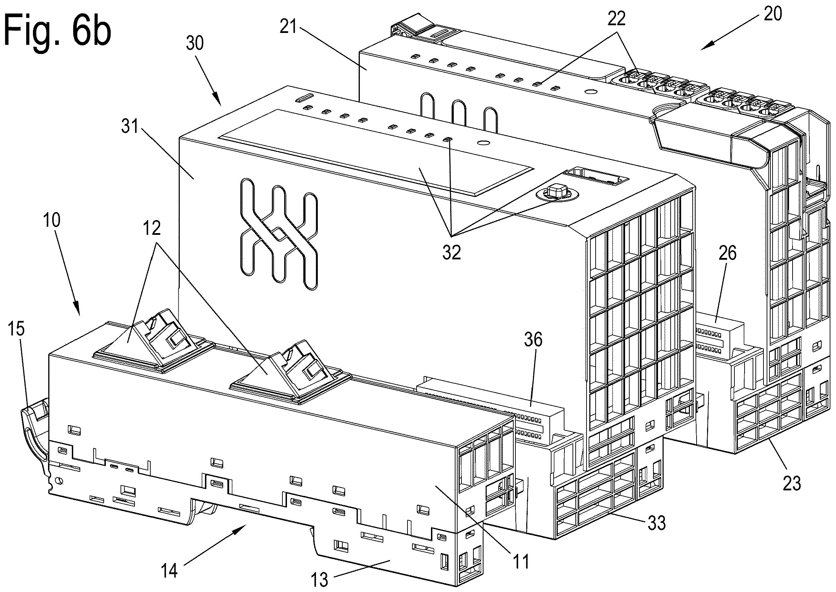

In den Figuren 6 bis 8 ist eine weitere Ausführungsform eines Automatisierungsgerätes gemäß der vorliegenden Erfindung angegeben. Bei der in diesen Figuren gezeigten Ausführungsform ist das Automatisierungsgerät ein Steuerungsrechner 30, der mit einem Anschlussmodul 10 verbunden ist, dass wie in den zuvor gezeigten Ausführungsbeispielen Feldbusanschlüsse 12 bereitstellt.

Wie bei dem in den Figuren 1 bis 5 dargestellten Automatisierungsgerät weist auch das als Steuerungsrechner ausgebildete Automatisierungsgerät ein Hauptmodul 30 auf, das mit dem Anschlussmodul 10 mechanisch und elektrisch gekoppelt ist.

Der Steuerungsrechner kommuniziert mit Feldgeräten, über die Signale ausgegeben oder eingelesen werden können. Die Feldgeräte sind dabei über die dargestellten Feldbusanschlüsse 12 direkt oder indirekt über einen Feldbuskoppler, beispielsweise einen in den Figuren 1-5 dargestellten Feldbuskoppler, angebunden.

Bei dem dargestellten Ausführungsbeispiel ist zusätzlich ein Hauptmodul 20 eines Feldbuskopplers gemäß einem Ausführungsbeispiel der Figuren 1 bis 4 unmittelbar mit dem Hauptmodul 30 des Steuerungsrechners verbunden. Dieses ist möglich, da das Steuerungshauptmodul 30 an der dem Anschlussmodul 10 gegenüberliegenden Seite mit einem in den Figuren nicht sichtbaren Steckverbinder ausgestattet ist, der in den Gegensteckverbinder 26 des Feldbushauptmoduls 20 eingreift. Auf diese Weise können Informationen, die zwischen dem Steuerungsrechner und dem Feldbuskoppler üblicherweise über den Feldbus ausgetauscht werden, unmittelbar zwischen dem Hauptmodul 30 des Steuerungsrechners und dem Hauptmodul 20 des Feldbuskopplers transferiert werden. Es entsteht auf diese Weise eine kompaktes Automatisierungssytem, das sowohl den Steuerungsrechner umfasst, als auch einen Feldbuskoppler, an dem entsprechende busfähige Module angeschlossen werden können.

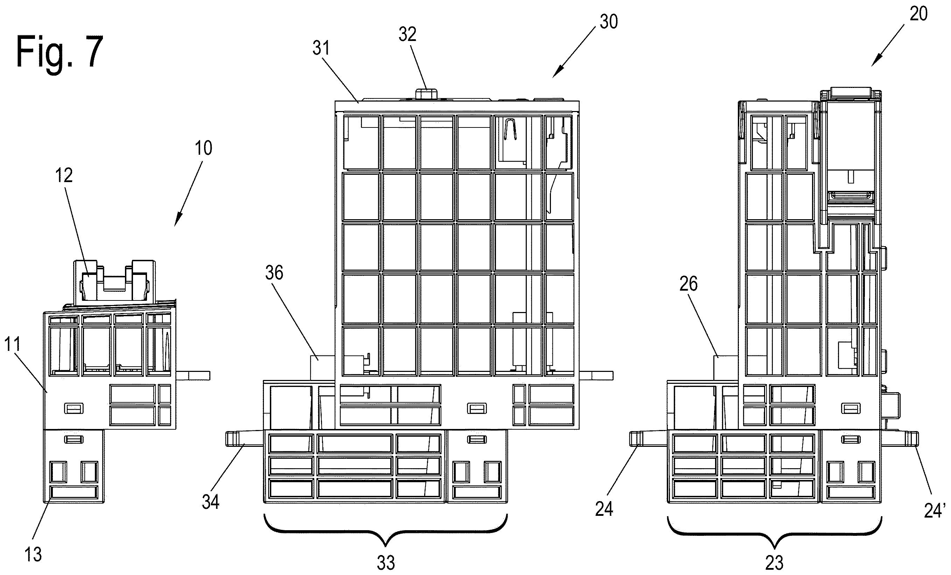

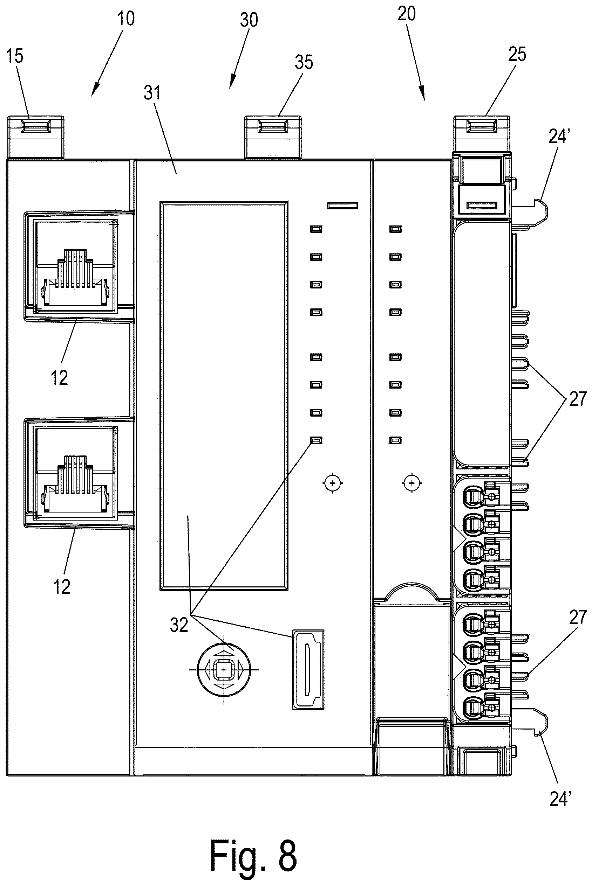

Das dargestellte System aus Hauptmodul 30 mit Anschlussmodul 10 und angekoppeltem Hauptmodul 20 des Feldbuskopplers ist in der Figur 6a in einem zusammengesetzten Zustand und in Figur 6b mit voneinander getrennten Modulen in einer perspektivischen Ansicht dargestellt. Figur 7 zeigt eine Seitenansicht der getrennten Module und Figur 8 eine Draufsicht auf die Module im zusammengefügten Zustand.

Bei dem Ausführungsbeispiel der Figuren 6 bis 8 ist bei dem Hauptmodul 30 ein mehrteiliges Gehäuse eingesetzt, mit einem Gehäuseoberteil 31 und einem Gehäuseunterteil 33. Auf der Oberseite des Gehäuseoberteils 31 sind ähnlich wie bei dem Hauptmodul 20 des Feldbuskopplers Anschluss-, Anzeige und Einstellelemente 32 angeordnet. Beispielhaft ist hier neben Leuchtioden als Statusanzeigen ein Anzeigefeld (Display) dargestellt, sowie ein USB Anschluss und ein mit dem Finger betätigbarer Miniatur-Joystick zur Bedienung.

Das Gehäuseunterteil 33 ist zur Seite des Anschlussmoduls 10 hin analog aufgebaut wie das Gehäuseunterteil 23 des Feldbuskoppler- Hauptmoduls 20. Zur gegenüberliegenden Seite hin ist das Gehäuseunterteil 33 analog aufgebaut wie die entsprechende Seite des Anschlussmoduls 10, um die Kopplung zum Feldbuskoppler-Hauptmodul 20 zu ermöglichen. Die Draufsicht in Figur 8 zeigt, dass wiederum ein Entriegelungshebel 35 vorgesehen ist, mit dem eine erfolgte Verrastung des Hauptmoduls 30 auf eine Hutschiene erfolgen kann. Die Hutschienenaufnahme des Hauptmoduls 30 selbst ist in den Figuren nicht sichtbar.

Bezüglich des Betriebsverfahrens wird auf die Beschreibung zu Figur 5 verwiesen. Auch bei einer Steuerung als Automatisierungsgerät können über dem integrierten nichtflüchtigen Speicher vom Hauptmodul 30 Informationen zur Kompatibilität der Module, zu Lizenzen und/oder im Hinblick auf Softwareaktualisierungen von Firmware des Hauptmoduls 30 eingelesen werden.

### Bezugszeichen

- 10: Anschlussmodul
- 11: Gehäuseoberteil
- 12: Feldbusanschluss
- 13: Gehäuseunterteil
- 14: Hutschienenaufnahme
- 15: Entriegelungshebel
- 16: Steckverbinder
- 17: Einstellelement

- 20: Hauptmodul (Feldbuskoppler)
- 21: Gehäuseoberteil
- 22: Anschluss, Anzeige
- 23: Gehäuseunterteil
- 24: Kupplungsmittel
- 24': weiteres Kupplungsmittel
- 25: Entriegelungshebel
- 26: Gegensteckverbinder
- 27: Busanschluss

- 30: Hauptmodul (Steuerung)
- 31: Gehäuseoberteil
- 32: Anschluss, Anzeige, Einstellelement
- 33: Gehäuseunterteil
- 34: Kupplungsmittel
- 35: Entriegelungshebel
- 36: Gegensteckverbinder

- 100: Steuereinheit
- 101: Feldbus-Schnittstelle
- 102: Schnittstellentreiber für nichtflüchtigen Speicher
- 103: nichtflüchtiger Speicher

- 200: Mikrocontroller
- 201,202,204: Schnittstellentreiber
- 203: Speicher

## Patentansprüche

1. Verfahren zum Betreiben eines Automatisierungsgeräts, das ein Feldbuskoppler und/oder ein Steuerungsrechner ist, umfassend ein Hauptmodul (20, 30) und ein austauschbares Anschlussmodul (10), wobei in dem Anschlussmodul (10) ein Feldbusanschluss (12) des Automatisierungsgeräts angeordnet ist, und wobei in dem austauschbaren Anschlussmodul (10) ein nichtflüchtiger Speicher (103) angeordnet ist, der von dem Hauptmodul (20, 30) des Automatisierungsgeräts auslesbar ist, mit den folgenden Schritten:
- Verbinden des Hauptmoduls (20, 30) des Automatisierungsgeräts mit dem Anschlussmodul (10);
- Auslesen des nichtflüchtigen Speichers (103) des Anschlussmoduls (10) durch das Hauptmodul (20, 30) über einen Daten-Übertragungsweg, der getrennt von einem Daten-Übertragungsweg der Daten ist, die an dem Feldbusanschluss (12) ausgegeben werden;
- Feststellen von eventuell vorliegenden Inkompatibilitäten zwischen dem Hauptmodul (20, 30) und dem Anschlussmodul (10) anhand der aus dem nichtflüchtigen Speicher (103) ausgelesenen Daten und
- Betreiben des Automatisierungsgeräts wenn keine Inkompatibilitäten festgestellt werden.

2. Verfahren nach Anspruch 1, bei dem die Inkompatibilitäten Software, Hardware oder Lizenzen betreffen.

3. Verfahren nach Anspruch 1 oder 2, bei dem Daten des nichtflüchtigen Speichers (103) des Anschlussmoduls (10) innerhalb des Hauptmoduls (20, 30) zur Behebung eventuell festgestellter Inkompatibilitäten eingesetzt werden.

4. Verfahren nach Anspruch 3, bei dem Daten des nichtflüchtigen Speichers (103) des Anschlussmoduls (10) zur Aktualisierung von Betriebssoftware, insbesondere Firmware, des Hauptmoduls (20, 30) eingesetzt werden.

5. Verfahren nach einem der Ansprüche 1 bis 4, bei dem von dem Anschlussmodul (10) zusätzlich ein funkbasierter Kommunikationskanal bereitgestellt wird.

6. Feldbuskoppler und/oder Steuerungsrechner, umfassend ein Hauptmodul (20, 30) mit einem Busanschluss (27), wobei über den Busanschluss (27) busfähige Module an das Hauptmodul (20, 30) anschließbar sind, und umfassend ein austauschbares Anschlussmodul (10), in dem ein Feldbusanschluss (12) angeordnet ist, wobei in dem austauschbaren Anschlussmodul (10) ein nichtflüchtiger Speicher (103) angeordnet ist, der von dem Hauptmodul (20, 30) auslesbar ist, **dadurch gekennzeichnet, dass** zwischen dem Hauptmodul (20, 30) und dem Anschlussmodul (10) ein Daten-Übertragungsweg für den nichtflüchtiger Speicher (103) ausgebildet ist, der getrennt von einem Daten-Übertragungsweg für den Feldbusanschluss (12) ist, und dass der Feldbuskoppler und/oder der Steuerungsrechner zur Durchführung eines Verfahrens gemäß einem der Ansprüche 1 bis 5 eingerichtet ist.

7. Feldbuskoppler und/oder Steuerungsrechner nach Anspruch 6, bei dem der nichtflüchtige Speicher (103) des Anschlussmoduls (10) ein Flashspeicher, ein ferroelektrischer Speicher oder ein EEPROM ist.

8. Feldbuskoppler und/oder Steuerungsrechner nach Anspruch 7, bei dem der nichtflüchtige Speicher (103) des Anschlussmoduls (10) auf einer Leiterplatte des Anschlussmoduls (10) eingelötet ist, die zudem Bausteine eines Schnittstellentreibers (101) und/oder einer zentralen Steuereinheit(100) zum Betreiben des Feldbusanschlusses (12) aufweist.

9. Feldbuskoppler und/oder Steuerungsrechner nach einem der Ansprüche 6 bis 8, bei dem das Anschlussmodul (10) einen Steckverbinder (16) zur Verbindung mit dem Hauptmodul (20, 30) aufweist, wobei der Steckverbinder (16) im Anschlussmodul (10) direkt oder indirekt mit dem nichtflüchtigen Speicher (103) gekoppelt ist.

10. Feldbuskoppler und/oder Steuerungsrechner nach Anspruch 9, bei dem 2. ein zusätzlicher Steckverbinder (16) zum Übertragen von Daten zwischen dem Hauptmodul (20, 30) und dem Feldbusanschluss (12) des Anschlussmoduls (10) eingerichtet ist.

11. Feldbuskoppler und/oder Steuerungsrechner nach einem der Ansprüche 6 bis 10, bei dem das Hauptmodul (20, 30) und/oder das Anschlussmodul (10) Kupplungsmittel (24) zur mechanischen Verbindung des Anschlussmoduls (10) an das Hauptmodul (20, 30) aufweisen.

12. Feldbuskoppler und/oder Steuerungsrechner nach Anspruch 11, bei dem die Kupplungsmittel (24) als Rasthaken ausgebildet sind.

13. Feldbuskoppler und/oder Steuerungsrechner nach einem der Ansprüche 6 bis 12, bei dem das Hauptmodul (20, 30) und/oder das Anschlussmodul (10) zur Montage auf einer Tragschiene eingerichtet sind und insbesondere eine Hutschienenaufnahme (14) aufweisen.

## Claims

1. Method for operating an automation device which is a field bus coupler and/or a control computer, comprising a main module (20, 30) and an interchangeable connection module (10), wherein a field bus port (12) of the automation device is arranged in the connection module (10), and wherein a non-volatile memory (103) which can be read by the main module (20, 30) of the automation device is arranged in the interchangeable connection module (10), having the following steps:
- connecting the main module (20, 30) of the automation device to a connection module (10);
- reading of the non-volatile memory (103) of the connection module (10) by the main module (20, 30) via a data transmission path which is separate from a data transmission path of the data which are output at the field bus port (12);
- determining any existing incompatibilities between the main module (20, 30) and the connection module (10) on the basis of the data read from the non-volatile memory (103), and
- operating the automation device, if no incompatibilities are detected.

2. The method according to claim 1, in which the incompatibilities relate to software, hardware or licenses.

3. The method according to claim 1 or 2, in which data from the non-volatile memory (103) of the connection module (10) are used in the main module (20, 30) to rectify any incompatibilities that may be detected.

4. The method according to claim 3, in which data from the non-volatile memory (103) of the connection module (10) are used to update operational software, particularly firmware, in the main module (20, 30).

5. The method according to one of claims 1 to 4, in which a radio-based communication channel is additionally provided by the connection module (10).

6. Field bus coupler and/or control computer, comprising a main module (20, 30) with a bus connection (27), wherein bus-capable modules can be connected to the main module (20, 30) via the bus connection (27), and comprising an interchangeable connection module (10) in which a field bus port (12) is arranged, wherein a non-volatile memory (103) is arranged in the interchangeable connection module (10), which memory (103) can be read out by the main module (20, 30), **characterized in that** a data transmission path for the non-volatile memory (103) is formed between the main module (20, 30) and the connection module (10), which is separate from a data transmission path for the field bus connection (12), and **in that** the field bus coupler and/or the control computer is adapted to carry out a method according to one of claims 1 to 5.

7. Field bus coupler and/or control computer according to claim 6, in which the non-volatile memory (103) of the connection module (10) is a flash memory, a ferroelectric memory or an EEPROM.

8. Field bus coupler and/or control computer according to claim 7, in which the non-volatile memory (103) of the connection module (10) is soldered onto a circuit board of the connection module (10), which also comprises components of an interface driver (101) and/or a central control unit (100) for operating the fieldbus port (12).

9. Field bus coupler and/or control computer according to one of claims 6 to 8, in which the connection module (10) has a plug connector (16) for connection with the main module (20, 30), wherein the plug connector (16) in the connection module (10) is coupled directly or indirectly to the non-volatile memory (103).

10. Field bus coupler and/or control computer according to claim 9, in which an additional plug connector (16) is configured to transmit data between the main module (20, 30) and the fieldbus port (12) of the connection module (10).

11. Field bus coupler and/or control computer according to one of claims 6 to 10, in which the main module (20, 30) and/or the connection module (10) have coupling means (24) for mechanically connecting the connection module (10) to the main module (20, 30).

12. Field bus coupler and/or control computer according to claim 11, in which the coupling means (24) are embodied as locking hooks.

13. Field bus coupler and/or control computer according to one of claims 6 to 12, in which the main module (20, 30) and/or the connection module (10) are configured for mounting on a mounting rail, and particularly have a snap-on mounting rail recess (14).

## Revendications

1. Procédé pour faire fonctionner un appareil d'automatisation qui est un coupleur de bus de terrain et/ou un ordinateur de commande, comprenant un module principal (20, 30) et un module de branchement (10) interchangeable, dans lequel un branchement de bus de terrain (12) de l'appareil d'automatisation est disposé dans le module de branchement (10) et une mémoire non volatile (103) pouvant être lue par le module principal (20, 30) est disposée dans le module de branchement (10) interchangeable, comprenant les étapes suivantes :
- connexion du module principal (20, 30) de l'appareil d'automatisation au module de branchement (10) ;
- lecture de la mémoire non volatile (103) du module de branchement (10) par le module principal (20, 30) via un trajet de transmission des données séparé d'un trajet de transmission des données émises en sortie sur le branchement de bus de terrain (12) ;
- détermination d'éventuelles incompatibilités entre le module principal (20, 30) et le module de branchement (10) à l'aide des données lues à partir de la mémoire non volatile (103) et
- fonctionnement de l'appareil d'automatisation si aucune incompatibilité n'est constatée.

2. Procédé selon la revendication 1, dans lequel les incompatibilités concernent les logiciels, le matériel ou les licences.

3. Procédé selon la revendication 1 ou 2, dans lequel les données de la mémoire non volatile (103) du module de branchement (10) sont utilisées dans le module principal (20, 30) pour corriger les incompatibilités éventuellement constatées.

4. Procédé selon la revendication 3, dans lequel les données de la mémoire non volatile (103) du module de branchement (10) sont utilisées pour actualiser un logiciel d'exploitation, en particulier un microprogramme, du module principal (20, 30).

5. Procédé selon l'une des revendications 1 à 4, dans lequel le module de branchement (10) fournit en outre un canal de communication par radio.

6. Coupleur de bus de terrain et/ou ordinateur de commande, comprenant un module principal (20, 30) avec un branchement de bus (27), dans lequel des modules peuvent être connectés au module principal (20, 30) via le branchement de bus (27) et qui comprend un module de branchement (10) interchangeable dans lequel est disposé un branchement de bus de terrain (12), une mémoire non volatile (103) qui peut être lue par le module principal (20, 30) étant disposée dans le module de branchement (10), **caractérisé en ce qu'**est formé entre le module principal (20, 30) et le module de branchement (10) un trajet de transmission des données pour la mémoire non volatile (103) qui est séparé d'un trajet de transmission des données pour le branchement de bus de terrain (12), et **en ce que** le coupleur de bus et/ou l'ordinateur de commande sont aménagés pour exécuter un procédé selon l'une des revendications 1 à 5.

7. Coupleur de bus de terrain et/ou ordinateur de commande selon la revendication 6, dans lequel la mémoire non volatile (103) du module de branchement (10) est une mémoire Flash, une mémoire ferroélectrique ou une EEPROM.

8. Coupleur de bus de terrain et/ou ordinateur de commande selon la revendication 7, dans lequel la mémoire non volatile (103) du module de branchement (10) est brasée sur une carte de circuits du module de branchement (10) qui comporte en outre des composants d'un pilote d'interface (101) et/ou d'une unité de commande centrale (100) pour le pilotage du branchement de bus de terrain (12).

9. Coupleur de bus de terrain et/ou ordinateur de commande selon l'une des revendications 6 à 8, dans lequel le module de branchement (10) présente un connecteur enfichable (16) pour la connexion au module principal (20, 30), lequel connecteur enfichable (16) est couplé directement ou indirectement à la mémoire non volatile (103) dans le module de branchement (10).

10. Coupleur de bus de terrain et/ou ordinateur de commande selon la revendication 9, dans lequel un connecteur enfichable supplémentaire (16) est aménagé pour la transmission de données entre le module principal (20, 30) et le branchement de bus de terrain (12) du module de branchement (10).

11. Coupleur de bus de terrain et/ou ordinateur de commande selon l'une des revendications 6 à 10, dans lequel le module principal (20, 30) et/ou le module de branchement (10) présentent des moyens de couplage (24) pour l'assemblage mécanique du module de branchement (10) sur le module principal (20, 30).

12. Coupleur de bus de terrain et/ou ordinateur de commande selon la revendication 11, dans lequel les moyens de couplage (24) sont conçus comme des crochets d'enclenchement.

13. Coupleur de bus de terrain et/ou ordinateur de commande selon l'une des revendications 6 à 12, dans lequel le module principal (20, 30) et/ou le module de branchement (10) sont aménagés en vue de leur montage sur un rail porteur et présentent en particulier un réceptacle pour un rail oméga (14).
